# EUROPÄISCHE PATENTANMELDUNG

(11) **EP 3 958 301 A1**
(43) Veröffentlichungstag der Anmeldung: **23.02.2022**
(21) Anmeldenummer: 20192063.4
(22) Anmeldetag: 21.08.2020
(51) Int. Cl.: H01L 23/053

(54) **LEISTUNGSMODUL MIT MINDESTENS EINEM LEISTUNGSHALBLEITER UND EINEM SUBSTRAT**

(71) Anmelder: Siemens Aktiengesellschaft, 80333 München (DE)
(72) Erfinder: Werner, Ronny, 90419 Nürnberg (DE); Bigl, Thomas, 91074 Herzogenaurach (DE)

(57) **Zusammenfassung**

Die Erfindung betrifft ein Leistungsmodul (2) mit mindestens einem Leistungshalbleiter (6) und einem Substrat (8). Um ein Leistungsmodul (2) anzugeben, welches, im Vergleich zum Stand der Technik, kompakter, kostengünstiger und flexibler zu fertigen ist, wird vorgeschlagen, dass das Substrat (8) zumindest auf einer dem Leistungshalbleiter (6) zugewandten Seite eine, insbesondere strukturierte, Substratmetallisierung (12, 14) aufweist, wobei der mindestens eine Leistungshalbleiter (6) stoffschlüssig mit der Substratmetallisierung (12, 14) verbunden ist, wobei ein Gehäuse (4) derartig mit dem Substrat (8) verbunden ist, dass der mindestens eine Leistungshalbleiter (6) zumindest teilweise vom Gehäuse (4) umgeben ist, wobei das Gehäuse (4) aus einem dielektrischen Werkstoff hergestellt ist und zumindest auf einer Oberfläche (20, 22) eine Metallisierung (24) aufweist.

## Beschreibung

Die Erfindung betrifft ein Leistungsmodul mit mindestens einem Leistungshalbleiter und einem Substrat.

Ferner betrifft die Erfindung einen Stromrichter mit mindestens einem derartigen Leistungsmodul.

Darüber hinaus betrifft die Erfindung ein Verfahren zur Herstellung eines Leistungsmoduls mit mindestens einem Leistungshalbleiter und einem Substrat.

In derartigen Stromrichtern werden in der Regel abgeschlossene Leistungsmodule beispielweise über eine massive metallische Bodenplatte, auf einen Kühlkörper aufgeschraubt. Unter einem Stromrichter ist beispielsweise ein Gleichrichter, ein Wechselrichter, ein Umrichter oder ein Gleichspannungswandler zu verstehen.

Die Schaltungen der Leistungsmodule sind zumindest teilweise von einem Kunststoffgehäuse umgeben. Pins zur Kontaktierung der Schaltungen nach außen werden üblicherweise eingespritzt, eingeklebt oder eingepresst. Insbesondere beim Einspritzen oder beim Einkleben der Pins fallen hohe Fertigungskosten an. Beim Einpressen hingegen ergeben sich erhöhte Anforderungen hinsichtlich der Toleranzen, z.B. von metallisierten Bohrungen, sodass zusätzliche Kosten anfallen.

Vor diesem Hintergrund ist es eine Aufgabe der vorliegenden Erfindung, ein Leistungsmodul anzugeben, welches, im Vergleich zum Stand der Technik, kompakter, kostengünstiger und flexibler zu fertigen ist.

Die Aufgabe wird erfindungsgemäß gelöst durch ein Leistungsmodul mit mindestens einem Leistungshalbleiter und einem Substrat, wobei das Substrat zumindest auf einer dem Leistungshalbleiter zugewandten Seite eine, insbesondere strukturierte, Substratmetallisierung aufweist, wobei der mindestens eine Leistungshalbleiter stoffschlüssig mit der Substratmetallisierung verbunden ist, wobei ein Gehäuse derartig mit dem Substrat verbunden ist, dass der mindestens eine Leistungshalbleiter zumindest teilweise vom Gehäuse umgeben ist, wobei das Gehäuse aus einem dielektrischen Werkstoff hergestellt ist und zumindest auf einer Oberfläche eine Metallisierung aufweist.

Ferner wird die Aufgabe erfindungsgemäß durch einen Stromrichter mit mindestens einem derartigen Leistungsmodul gelöst.

Darüber hinaus wird die Aufgabe erfindungsgemäß gelöst durch ein Verfahren zur Herstellung eines Leistungsmoduls mit mindestens einem Leistungshalbleiter und einem Substrat, wobei das Substrat zumindest auf einer dem Leistungshalbleiter zugewandten Seite eine, insbesondere strukturierte, Substratmetallisierung aufweist, wobei der mindestens eine Leistungshalbleiter stoffschlüssig mit der Substratmetallisierung verbunden wird, wobei ein Gehäuse derartig mit dem Substrat verbunden wird, dass der mindestens eine Leistungshalbleiter zumindest teilweise vom Gehäuse umgeben ist, wobei das Gehäuse aus einem dielektrischen Werkstoff hergestellt wird und zumindest eine Oberfläche metallisiert wird.

Die in Bezug auf das Leistungsmodul nachstehend angeführten Vorteile und bevorzugten Ausgestaltungen lassen sich sinngemäß auf den Stromrichter und das Verfahren übertragen.

Der Erfindung liegt die Überlegung zugrunde, ein Leistungsmodul kostengünstiger und flexibler zu fertigen, indem auf ein Gehäuse, welches auf einem dielektrischen Werkstoff hergestellt ist, eine Metallisierung aufgebracht wird. Beispielsweise enthält die Metallisierung Kupfer oder eine Kupferlegierung. Insbesondere wird die Metallisierung galvanisch, durch Sputtern oder additiv aufgebracht. Der dielektrische Werkstoff ist beispielsweise ein Kunststoff insbesondere PA (Polyamid), PPS (Polyphenylensulfid) oder
PBT (Polybutylenterephthalat). Der Kunststoff kann eine Füllung aus Metallpartikeln, Keramikpartikeln, Glasfasern oder Kohlefasern aufweisen.

Das Leistungsmodul weist neben dem Gehäuse mindestens einen Leistungshalbleiter und ein Substrat auf, wobei der Leistungshalbleiter stoffschlüssig mit einer, insbesondere strukturierten, Substratmetallisierung verbunden ist. Der Leistungshalbleiter ist beispielsweise als Transistor, insbesondere als Insulated-Gate-Bipolar-Transistor (IGBT), als Metalloxide-Semiconductor-Field-Effect-Transistor (MOSFET) oder als Feldeffekttransistor, oder als Diode ausgeführt. Das Gehäuse ist derartig mit dem Substrat verbunden, dass der mindestens eine Leistungshalbleiter zumindest teilweise vom Gehäuse umgeben ist. Durch die auf dem Gehäuse aufgebrachte Metallisierung wird eine Leitungsführung ermöglicht, welche beispielswiese eine Kontaktierung von Anschlüssen des mindestens einen Leistungshalbleiters nach außen und/oder eine, insbesondere elektromagnetische, Schirmung des mindestens einen Leistungshalbleiters ermöglicht. Beispielsweise bei einer Kontaktierung von Anschlüssen des mindestens einen Leistungshalbleiters ist die Metallisierung mit der oberen Substratmetallisierung verbunden. Insbesondere bei einer Schirmung des mindestens einen Leistungshalbleiters ist die Metallisierung des Gehäuses mit einem Bezugspotential des Leistungsmoduls verbunden, welches beispielsweise auf einer unteren Substratmetallisierung angeordnet ist. Eine derartige Leitungsführung ist, insbesondere im Vergleich zu diskreten Pins, kostengünstig und flexibel. Darüber hinaus wird durch die Metallisierung auf dem dielektrischen Werkstoff des Gehäuses Bauraum eingespart.

Eine weitere Ausführungsform sieht vor, dass das Gehäuse stoffschlüssig mit dem Substrat verbunden ist. Beispielsweise ist die Metallisierung des Gehäuses stoffschlüssig und elektrisch leitfähig mit der oberen Substratmetallisierung verbunden. Eine derartige stoffschlüssige und elektrisch leitfähige Verbindung wird durch Löten, Sintern oder adhäsiv, z.B. durch einen elektrisch leitfähigen Kleber, hergestellt. Durch eine derartige Verbindung sind keine zusätzlichen Verbindungsmittel wie Schrauben erforderlich, was Kosten einspart.

Eine weitere Ausführungsform sieht vor, dass die Metallisierung des Gehäuses strukturiert ausgeführt ist. Beispielsweise ermöglicht eine strukturierte Metallisierung Leiterbahnen für Kontakte, um beispielsweise eine Gateansteuerung und/oder einen Hilfsemitter zu realisieren, was zu einer Kostenersparnis und zu einer Reduzierung des Platzbedarfs führt. Ferner führt beispielsweise eine auf dem Gehäuse angeordnete Gateansteuerung zu einer Verkürzung der Zuleitungen, was parasitäre Effekte, insbesondere parasitäre Induktivitäten, reduziert und ein Schaltverhalten des mindestens einen Leistungshalbleiters verbessert.

Eine weitere Ausführungsform sieht vor, dass das Gehäuse als MID-Formteil ausgeführt ist. MID steht für "Moulded-Interconnect-Device". Ein MID-Formteil, insbesondere ein 3D MID-Formteil, zeichnet sich dadurch aus, dass auf einem dielektrischen Werkstoff wie beispielsweise einem Kunststoff metallische Leiterbahnen und/oder metallische Flächen auf- oder eingebracht sind. Insbesondere durch die Verwendung von Zweikomponentenspritzguss, wobei eine Komponente des Zweikomponentenspritzguss-Verfahrens elektrisch leitfähig, insbesondere metallisch, ist, wird die flexible Herstellung eines kompakten 3D MID-Formteils ermöglicht.

Eine weitere Ausführungsform sieht vor, dass das Gehäuse zumindest eine elektronische Komponente, welche mit der Metallisierung des Gehäuses verbunden ist, aufweist. Insbesondere durch MID-Technik sind elektronische Komponente, wie z.B. Vorwiderstände und/oder Sensoren in das Gehäuse oder auf dessen Außenseite integrierbar. Auf diese Weise wird eine verbesserte Zuverlässigkeit des Leistungsmoduls erreicht.

Eine weitere Ausführungsform sieht vor, dass die elektronische Komponente innerhalb des Gehäuses angeordnet ist. Durch eine Anordnung von elektronischen Komponenten innerhalb des Gehäuses werden parasitäre Effekte, insbesondere parasitäre Induktivitäten, reduziert, was sich positiv auf ein Schaltverhalten des mindestens einen Leistungshalbleiters auswirkt.

Eine weitere Ausführungsform sieht vor, dass die elektronische Komponente als Sensor ausgeführt ist. Beispielsweise ist die elektronische Komponente als Temperatursensor ausgeführt, welcher, insbesondere bei einer Anordnung innerhalb des Gehäuses, eine Überwachung einer Temperatur nahe am mindestens einen Leistungshalbleiter ermöglicht, wodurch eine verbesserte Zuverlässigkeit des Leistungsmoduls erreicht wird.

Eine weitere Ausführungsform sieht vor, dass ein Power-Board im Wesentlichen parallel zu einer Substratoberfläche verlaufend angeordnet ist, wobei das Gehäuse als Bauteilträger für das Power-Board ausgeführt ist. Neben dem Schutz des mindestens einen Leistungshalbleiters vor äußeren Einflüssen wird die Funktion des Gehäuses um eine mechanische Tragfunktion erweitert, was zu einer Kostenersparnis und zu einer Reduzierung des Platzbedarfs führt.

Eine weitere Ausführungsform sieht vor, dass das Power-Board über die Metallisierung des Gehäuses mit dem mindestens einen Leistungshalbleiter verbunden ist. Eine derartige Leitungsführung ist, insbesondere im Vergleich zu diskreten Pins, kostengünstig und flexibel. Darüber hinaus wird durch die Metallisierung auf dem dielektrischen Werkstoff des Gehäuses Bauraum eingespart.

Eine weitere Ausführungsform sieht vor, dass das Power-Board über zumindest einen Federkontakt und/oder zumindest einen Druckkontakt elektrisch leitfähig mit der Metallisierung des Gehäuses verbunden ist. Derartige Kontakte ermöglichen eine, insbesondere hermetische, Abdichtung des Gehäuses. Ferner sind keine Durchkontaktierungen im Power-Board erforderlich. Ein Druckkontakt bietet zudem eine elektrisch und mechanisch stabile Verbindung während ein Federkontakt eine elektrisch stabile und mechanisch flexible Verbindung ermöglicht, wobei der Federkontakt, insbesondere bei starken mechanischen Belastungen, wie Vibrationen, die Wahrscheinlichkeit einer Rissbildung, z.B. bei Lötverbindungen, reduziert und damit die Zuverlässigkeit des Leistungsmoduls verbessert.

Im Folgenden wird die Erfindung anhand der in den Figuren dargestellten Ausführungsbeispiele näher beschrieben und erläutert.

Es zeigen:
- FIG 1: eine schematische Darstellung eines Leistungsmoduls mit einer ersten Ausführungsform eines Gehäuses,
- FIG 2: eine schematische Darstellung eines Leistungsmoduls mit einer zweiten Ausführungsform eines Gehäuses und
- FIG 3: eine schematische Darstellung eines Stromrichters mit einem Leistungsmodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

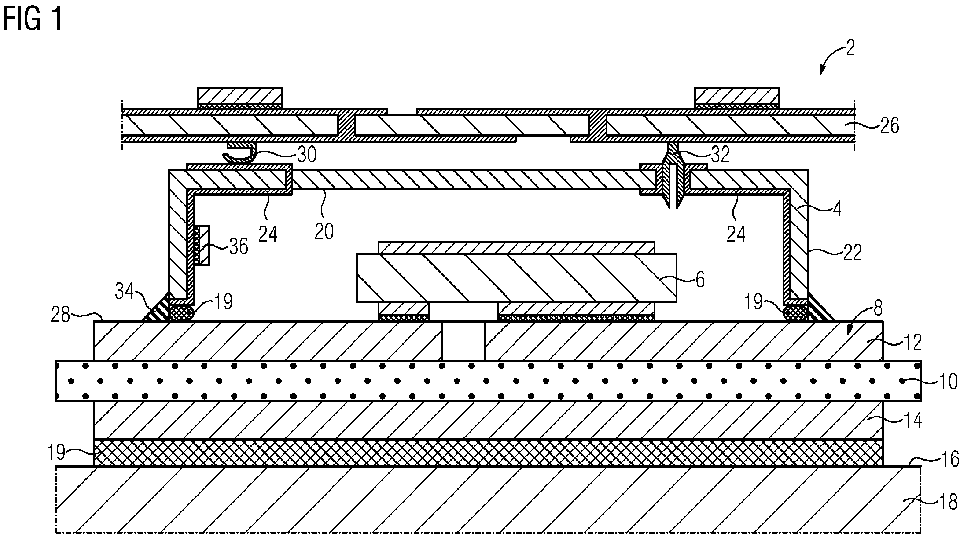

FIG 1 zeigt eine schematische Darstellung eines Leistungsmoduls 2 mit einer ersten Ausführungsform eines Gehäuses 4. Das Leistungsmodul 2 weist beispielhaft einen Leistungshalbleiter 6 auf. Der Leistungshalbleiter 6 ist beispielsweise als Transistor, insbesondere als Insulated-Gate-Bipolar-Transistor (IGBT), als Metalloxide-Semiconductor-Field-Effect-Transistor (MOSFET) oder als Feldeffekttransistor, oder als Diode ausgeführt. Insbesondere ist zumindest einem Transistor eine antiparallele Diode zugewiesen. Exemplarisch ist der Leistungshalbleiter 6 in FIG 1 als IGBT ausgeführt.

Das Leistungsmodul 2 weist darüber hinaus ein Substrat 8 auf, welches eine dielektrische Materiallage 10 mit einer Dicke von 25 µm bis 400 µm, insbesondere 50 µm bis 250 µm, umfasst. Die dielektrische Materiallage 10 ist aus einem keramischen Werkstoff, beispielsweise Aluminiumnitrid oder Aluminiumoxid, oder einen organischen Werkstoff, beispielsweise einem Polyamid hergestellt. Darüber hinaus weist das Substrat 8 eine, insbesondere strukturierte, beidseitige Substratmetallisierung 12, 14, welche beispielsweise aus Kupfer hergestellt ist, auf. Der mindestens eine Leistungshalbleiter 6 ist stoffschlüssig mit einer oberen Substratmetallisierung 12 verbunden. Die stoffschlüssige Verbindung wird durch Löten oder Sintern hergestellt. Bondverbindungen des Leistungshalbleiter 6 sind aus Gründen der Übersichtlichkeit in FIG 1 nicht dargestellt. Eine untere Substratmetallisierung 14 ist mit einer Grundplatte 18 verbunden. Die Grundplatte 18 ist beispielsweise als Kühlkörper, der aus Aluminium oder einer Aluminiumlegierung durch Strangpressen hergestellt ist, ausgeführt. Insbesondere ist eine stoffschlüssige Verbindung zur Grundplatte 18 durch Löten oder Sintern hergestellt. Alternativ ist eine thermisch leitfähige Verbindung über Wärmeleitpaste hergestellt.

Der mindestens eine Leistungshalbleiter 6 ist vom Gehäuse 4 umgeben, wobei das Gehäuse 4 stoffschlüssig mit der oberen Substratmetallisierung 12 des Substrats 8 verbunden ist. Die stoffschlüssige Verbindung wird beispielsweise über einen elektrisch leitfähigen Kleber oder durch Löten hergestellt.

Das Gehäuse ist aus einem dielektrischen Werkstoff hergestellt. Der dielektrische Werkstoff ist beispielsweise ein Kunststoff insbesondere PA (Polyamid), PPS (Polyphenylensulfid) oder PBT (Polybutylenterephthalat). Ferner ist das Gehäuse 4 einstückig ausgeführt und weist eine dem Leistungshalbleiter 6 zugewandte innere Oberfläche 20 und eine äußere Oberfläche 22 auf, wobei das Gehäuse auf den Oberflächen 20, 22 eine strukturierte Metallisierung 24 aufweist. Beispielsweise umfasst das Gehäuse 4 Anschlussstrukturen, insbesondere Leiterbahnen, für Kontakte, welche insbesondere eine Gateansteuerung und/oder einen Hilfsemitter enthalten.

Darüber hinaus ist das Gehäuse 4 als eine spritzgegossene Komponente nach der 3D MID-Technologie ausgeführt. Insbesondere durch die Verwendung von Zweikomponentenspritzguss, bei dem insbesondere eine Komponente elektrisch leitfähig ist, ist eine zumindest teilweise Integration der Leitungsführung in das Gehäuse 4 möglich. Beispielsweise sind Anschlüsse von der inneren Oberfläche 20 auf die äußere Oberfläche 22 führbar, wobei eine, insbesondere hermetische, Dichtigkeit des Gehäuses erhalten bleibt.

Ein Power-Board 26 ist im Wesentlichen parallel zu einer, insbesondere im Wesentlichen ebenen, Substratoberfläche 28 verlaufend angeordnet, wobei das Power-Board 26 über die Metallisierung 24 des Gehäuses 4 mit dem mindestens einen Leistungshalbleiter 6 verbunden ist. Beispielhaft ist das Power-Board 26 über einen Federkontakt 30 und einen Druckkontakt 32 elektrisch leitfähig mit der strukturierten Metallisierung 24 des Gehäuses 4 verbunden. Darüber hinaus ist das Gehäuse 4 auch im Bereich der Kontakte 30, 32, insbesondere hermetisch, dicht. Neben der elektrisch leitfähigen Verbindung zwischen dem Power-Board 26 und dem Leistungshalbleiter 6 hat das mittels 3D MID-Technologie gefertigte Gehäuse 4 die Funktion eines Bauteilträgers für das Power-Board 26.

Überdies ist das Gehäuse 4 zusätzlich mittels einer Dichtmasse 34, welche beispielsweise als ein isolierender Klebstoff ausgeführt ist, flüssigkeitsdicht mit der Substratoberfläche 28 verbunden. Darüber hinaus umfasst das Gehäuse 4 beispielhaft eine elektronische Komponente 36, welche mit der Metallisierung 24 des Gehäuses 4 verbunden ist. Die elektronische Komponente 36 ist insbesondere auf der dem Leistungshalbleiter (6) zugewandten inneren Oberfläche 20 des Gehäuses 4 angeordnet und beispielsweise als Sensor, insbesondere als Temperatursensor, ausgeführt.

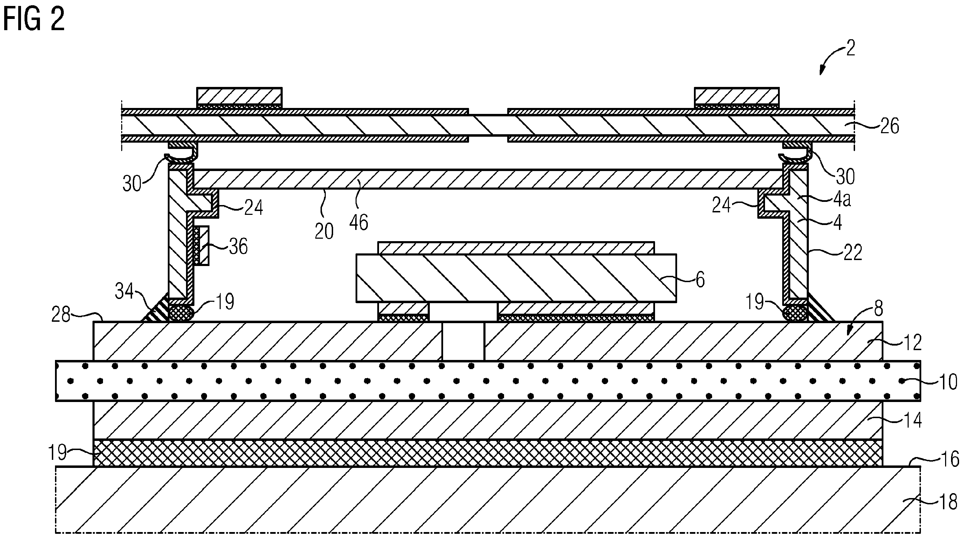

FIG 2 zeigt eine schematische Darstellung eines Leistungsmoduls 2 mit einer zweiten Ausführungsform eines Gehäuses 4. Das Gehäuse 4 ist zweiteilig ausgeführt und umfasst einen Gehäuserahmen 4a und einen Gehäusedeckel 4b. Zumindest der Gehäuserahmen 4a ist mittels 3D MID-Technologie hergestellt. Der Gehäusedeckel 4b kann aus einem anderen dielektrischen Werkstoff gefertigt sein als der Gehäuserahmen 4a. Insbesondere ist der Gehäusedeckel 4b, beispielsweise durch eine Formschlüssige Verbindung, flüssigkeitsdicht mit dem Gehäuserahmen 4a verbunden. Die weitere Ausführung des Leistungsmoduls 2 in FIG 2 entspricht der in FIG 1.

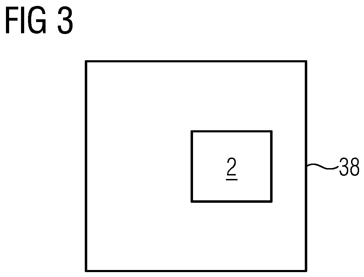

FIG 3 zeigt eine schematische Darstellung eines Stromrichters 38 mit einem Leistungsmodul 2. Der Stromrichter 38 kann mehr als ein Leistungsmodul 2 umfassen.

Zusammenfassend betrifft die Erfindung ein Leistungsmodul 2 mit mindestens einem Leistungshalbleiter 6 und einem Substrat 8. Um ein Leistungsmodul 2 anzugeben, welches, im Vergleich zum Stand der Technik, kompakter, kostengünstiger und flexibler zu fertigen ist, wird vorgeschlagen, dass das Substrat 8 zumindest auf einer dem Leistungshalbleiter 6 zugewandten Seite eine, insbesondere strukturierte, Substratmetallisierung 12, 14 aufweist, wobei der mindestens eine Leistungshalbleiter 6 stoffschlüssig mit der Substratmetallisierung 12, 14 verbunden ist, wobei ein Gehäuse 4 derartig mit dem Substrat 8 verbunden ist, dass der mindestens eine Leistungshalbleiter 6 zumindest teilweise vom Gehäuse 4 umgeben ist, wobei das Gehäuse 4 aus einem dielektrischen Werkstoff hergestellt ist und zumindest auf einer Oberfläche 20, 22 eine Metallisierung 24 aufweist.

## Patentansprüche

1. Leistungsmodul (2) mit mindestens einem Leistungshalbleiter (6) und einem Substrat (8),
wobei das Substrat (8) zumindest auf einer dem Leistungshalbleiter (6) zugewandten Seite eine, insbesondere strukturierte, Substratmetallisierung (12, 14) aufweist,
wobei der mindestens eine Leistungshalbleiter (6) stoffschlüssig mit der Substratmetallisierung (12, 14) verbunden ist,
wobei ein Gehäuse (4) derartig mit dem Substrat (8) verbunden ist, dass der mindestens eine Leistungshalbleiter (6) zumindest teilweise vom Gehäuse (4) umgeben ist,
wobei das Gehäuse (4) aus einem dielektrischen Werkstoff hergestellt ist und zumindest auf einer Oberfläche (20, 22) eine Metallisierung (24) aufweist.

2. Leistungsmodul (2) nach Anspruch 1,
wobei das Gehäuse (4) stoffschlüssig und/oder elektrisch leitfähig mit dem Substrat (8) verbunden ist.

3. Leistungsmodul (2) nach einem der Ansprüche 1 oder 2,
wobei die Metallisierung (34) des Gehäuses (4) strukturiert ausgeführt ist.

4. Leistungsmodul (2) nach einem der vorherigen Ansprüche,
wobei das Gehäuse (4) als MID-Formteil ausgeführt ist.

5. Leistungsmodul (2) nach einem der vorherigen Ansprüche,
wobei das Gehäuse (4) zumindest eine elektronische Komponente (36), welche mit der Metallisierung (24) des Gehäuses (4) verbunden ist, aufweist.

6. Leistungsmodul (2) nach Anspruch 5,
wobei die elektronische Komponente (36) innerhalb des Gehäuses (4) angeordnet ist.

7. Leistungsmodul (2) nach einem der Ansprüche 5 oder 6,
wobei die elektronische Komponente (36) als Sensor ausgeführt ist.

8. Leistungsmodul (2) nach einem der vorherigen Ansprüche,
wobei ein Power-Board (26) im Wesentlichen parallel zu einer Substratoberfläche (28) verlaufend angeordnet ist,
wobei das Gehäuse (4) als Bauteilträger für das Power-Board (26) ausgeführt ist.

9. Leistungsmodul (2) nach Anspruch 8,
wobei das Power-Board (26) über die Metallisierung (24) des Gehäuses (4) mit dem mindestens einen Leistungshalbleiter (6) verbunden ist.

10. Leistungsmodul (2) nach einem der Ansprüche 8 oder 9,
wobei das Power-Board (26) über zumindest einen Federkontakt (30) und/oder zumindest einen Druckkontakt (32) elektrisch leitfähig mit der Metallisierung (24) des Gehäuses (4) verbunden ist.

11. Stromrichter mit mindestens einem Leistungsmodul (2) nach einem der Ansprüche 1 bis 10.

12. Verfahren zur Herstellung eines Leistungsmoduls (2) mit mindestens einem Leistungshalbleiter (6) und einem Substrat (8),
wobei das Substrat (8) zumindest auf einer dem Leistungshalbleiter (6) zugewandten Seite eine, insbesondere strukturierte, Substratmetallisierung (12, 14) aufweist,
wobei der mindestens eine Leistungshalbleiter (6) stoffschlüssig mit der Substratmetallisierung (12, 14) verbunden wird,
wobei ein Gehäuse (4) derartig mit dem Substrat (8) verbunden wird, dass der mindestens eine Leistungshalbleiter (6) zumindest teilweise vom Gehäuse (4) umgeben ist,
wobei das Gehäuse (4) aus einem dielektrischen Werkstoff hergestellt wird und zumindest eine Oberfläche (20, 22) metallisiert wird.

13. Verfahren nach Anspruch 12,
wobei das Gehäuse (4) stoffschlüssig und/oder elektrisch leitfähig mit dem Substrat (8) verbunden wird.

14. Verfahren nach einem der Ansprüche 12 oder 13,
wobei zumindest eine elektronische Komponente (36) mit der Metallisierung (24) des Gehäuses (4) verbunden wird,
wobei die elektronische Komponente (36) innerhalb des Gehäuses (4) angeordnet wird.

15. Verfahren nach einem der Ansprüche 12 bis 14,
wobei ein Power-Board (26) im Wesentlichen parallel zu einer Substratoberfläche (28) verlaufend angeordnet wird,
wobei das Gehäuse (4) als Bauteilträger für das Power-Board (26) ausgeführt ist und
wobei das Power-Board (26) über die Metallisierung (24) des Gehäuses (4) mit dem mindestens einen Leistungshalbleiter (6) verbunden wird.
